# EUROPEAN PATENT APPLICATION

(11) **EP 2 546 872 A1**
(43) Date of publication of application: **16.01.2013**
(21) Application number: 11753374.5
(22) Date of filing: 08.03.2011
(51) Int. Cl.: H01L 23/36, H05K 7/20

(54) **HEAT INSULATION/HEAT DISSIPATION SHEET AND INTRA-DEVICE STRUCTURE**

(30) Priority: 10.03.2010 JP 2010053310
(71) Applicant: Nitto Denko Corporation, Ibaraki-shi, Osaka 567-8680 (JP)
(72) Inventor: SUZUKI Hidenori, Ibaraki-shi Osaka 567-8680 (JP); MIKURINO Kouichi, Ibaraki-shi Osaka 567-8680 (JP)
(74) Representative: Grünecker, Kinkeldey, Stockmair & Schwanhäusser
(86) International application number: PCT/JP2011/055417
(87) International publication number: WO 2011/111716

(57) **Abstract**

In a heat-generating component, such as electronic equipment having a heat-generating component mounted on a circuit board or the like, an assembled battery, or a heat-generating machine component, heat generated from the heat-generating component is efficiently dissipated, and the transfer of heat to a component to be protected, adjacent to the heat-generating component, is suppressed, thereby preventing a decrease in performance, and the like, due to the component to be protected being heated.

Therefore, the present invention is a heat insulation/heat dissipation sheet comprising a pressure-sensitive adhesive layer or a heat-conducting pressure-sensitive adhesive layer, a heat-conducting layer, a pressure-sensitive adhesive layer or a heat-insulating pressure-sensitive adhesive layer, a heat-insulating layer, and a pressure-sensitive adhesive layer or a heat-insulating pressure-sensitive adhesive layer laminated in order between the heat-generating component and the component to be protected, adjacent to the heat-generating component, for connecting the components. Further, the present invention is an intra-device structure comprising the heat insulation/heat dissipation sheet with the pressure-sensitive adhesive layer on a heat-conducting layer side thereof adhered to a heat-generating component side and the pressure-sensitive adhesive layer on a heat-insulating layer side thereof adhered to a component to be protected.

## Description

### [Technical Field]

The present invention relates to a heat insulation/heat dissipation sheet that, in electronic equipment having a heat-generating component mounted on a circuit board or the like, a secondary battery, or a general device, other than electronic equipment, comprising a heat-generating component, efficiently dissipates heat generated from the heat-generating component or the secondary battery and suppresses the transfer of heat to a component, equipment, or a device adjacent to the heat-generating component, and a device structure using a heat insulation/heat dissipation sheet.

### [Background Art]

In electronic equipment, such as household electrical appliances and cellular phones, heat dissipation measures for heat generated inside have become increasingly important for the reliability improvement of the products. In recent years, the miniaturization of equipment has advanced, and components are disposed in a narrow space at high density. Therefore, it is difficult to ensure a space where a heat dissipation member, such as a heat sink, is placed, and heat emitted from a heat-generating component, such as an IC element in a CPU, may be released directly to an enclosure via a heat-conducting member. Problems of this case are that the enclosure exterior has locally high temperature due to the transfer of the heat of the heat-generating component to the enclosure exterior, and a burn is caused by contact with a human body for a long time. Another problem is that with high density mounting, a component that dislikes heat, the control IC of another system, or the like is present near a heat-generating component, and receives the heat of the adjacent heat-generating component and receives adverse effects, such as malfunction and life decrease.
In nickel-hydrogen secondary batteries, lithium ion batteries, and the like used in devices such as electric cars, high energy density is required, and the mounting space is required to be as small as possible. Therefore, in the case of a high voltage and high capacity battery, a plurality of cells are connected in series or in parallel, and an assembled battery device in which several to several tens or several hundreds of cells are connected is used. Cells constituting such an assembled battery may generate heat due to an internal reaction. Heat generated in this manner heats adjacent cells each other, thus providing high temperature.
Since the performance and life of an assembled battery depend greatly on the temperature environment, degradation may be significant at high temperature.
In addition, other than electronic equipment, devices in which equipment that cannot be placed in a heating environment cannot be placed adjacent to, for example, such machine devices that generate frictional heat, also have similar problems.

In order to solve these problems, for example, Patent Literature 1 shows a method of avoiding local high temperature in an enclosure by placing a graphite sheet provided with a notch, on a heat-generating component. However, according to this method, when the site to which heat is transferred is another electronic component, rather than the enclosure, local high temperature is not caused, but large heat energy flows in as the entire system, and therefore, there is a risk of adversely affecting the operation and life of the electronic component.

In addition, Patent Literature 2 describes promoting a reduction in burn and discomfort by providing a heat-insulating layer on the outer surface of an enclosure that has high temperature due to heat from a heat-generating component. However, according to this method, heat emitted from the heat-generating component cannot be efficiently dissipated to the outside air by the heat insulation material, and therefore, heat remains inside and, as a result, may adversely affect other sites and components.

On the other hand, Patent Literature 3 shows a configuration in which by placing a sheet obtained by laminating a heat-conducting sheet and a heat insulation sheet, between a heat-generating component and an enclosure or the like, both the heat dissipation of the heat-generating component and heat insulation for the enclosure are intended. But, in an internal structure described in Patent Literature 3, for a heat conduction member, only a silicone rubber in which a heat-conducting filler is mixed is illustrated, and the silicone rubber is also effective for vibration measures, such as vibration insulation and sound insulation. Further, according to a diagram and its explanation, a heat conduction sheet formed of a silicone rubber layer contacts with a printed board around a heat-generating element as if forming a closed space around the heat-generating element. In addition, heat from the heat-generating component is accumulated in the heat conduction sheet. Further, a heat dissipation plate, a heat dissipation fin, a heat sink, a heat pipe, or the like is separately required for heat dissipation.
According to such description, the heat-generating element is positioned so as to be wrapped with the printed board and the heat-conducting sheet, and it is clear that hot air accumulates in the heat-generating element itself and its periphery. Therefore, it can be said that a heat dissipation plate, a heat dissipation fin, or the like is separately required on purpose.
Further, the silicone rubber layer is formed so as to also contribute to vibration measures, and therefore, it is needless to say that the silicone rubber layer needs to be a layer as thick as, for example, more than 1 mm. Moreover, it is described that a member such as a heat dissipation fin or a heat sink is attached to an end of the silicone rubber layer for heat dissipation, and also from such description, the silicone rubber layer is formed assuming that it needs to have such a thickness that these members can be attached to its end.
In Patent Literature 3, there is no description of to what extent the heat of the heat-generating component decreases, and to what extent heat transfer to the enclosure can be suppressed, and its effect is uncertain in many respects.

### [Citation List]

### [Patent Literature]

[Patent Literature 1] Japanese Patent Laid-Open No. 2009-094196
[Patent Literature 2] Japanese Patent Laid-Open No. 2000-148306
[Patent Literature 3] Japanese Patent Laid-Open No. 2000-106495

### [Summary of Invention]

### [Technical Problem]

The present invention has been made in view of the above circumstances, and it is an object of the present invention to provide a heat insulation/heat dissipation sheet that, in electronic equipment having a heat-generating component mounted on a circuit board or the like, a device in which a plurality of secondary batteries are placed adjacent to each other, or a general device, both efficiently dissipates heat generated from a heat-generating component, and suppresses the transfer of heat to a component to be protected, adjacent to the heat-generating component, thereby preventing a decrease in performance, and the like, due to the component to be protected being heated.

### [Solution to Problem]

The present inventors have invented a sheet that is formed by laminating a member showing heat insulation properties and a member showing heat conductivity, which are necessary for solving the above problem, in electronic equipment having a heat-generating component mounted on a circuit board or the like, and exhibits both a heat insulation function and a heat dissipation function.
Specifically, the present invention is a heat insulation/heat dissipation sheet comprising a heat-conducting layer, a pressure-sensitive adhesive layer or a heat-insulating pressure-sensitive adhesive layer, and a heat-insulating layer laminated in order between a heat-generating component and a component to be protected, adjacent to the heat-generating component, in a device, for connecting the components. Further, the present invention is an intra-device structure comprising the heat insulation/heat dissipation sheet connected with a heat-conducting layer side thereof facing a heat-generating component side and a heat-insulating layer side thereof facing a component to be protected, in a device.
In addition, in these sheet and intra-device structure, an area of the heat insulation/heat dissipation sheet may be larger than a footprint of the heat-generating component, or the heat insulation/heat dissipation sheet may be continuously placed not only on a surface of the component to be protected but also on at least one end of the component to be protected.

### [Advantageous Effect of Invention]

According to the present invention, the heat insulation/heat dissipation sheet can be disposed between a heat-generating component and a component to be protected, adjacent to the heat-generating component, in a device, and therefore, by dissipating and insulating heat from the heat-generating component, the component to be protected, which is susceptible to heat, can be prevented from receiving excessive heat. As a result, electronic equipment can function stably.

### [Brief Description of Drawings]

[Figure 1] Figure 1 is a conceptual diagram of the layer configuration of the heat insulation/heat dissipation sheet of the present invention.
[Figure 2] Figure 2 is a schematic diagram of a heat resistance value measurement device.
[Figure 3] Figure 3 is the structure of a heat generating site used in Examples.
[Figure 4] Figure 4 is a schematic diagram of a test device for a heat insulation/heat dissipation sheet used in Examples.
[Figure 5] Figure 5 is a diagram of a combination composed of a component to be protected, a heat-generating component, and a test piece, used in Example 10.
[Figure 6] Figure 6 is a schematic diagram of the test piece used in Example 10.
[Figure 7] Figures 7(A) to 7(D) are each a diagram of a combination of a test piece, a component to be protected, and a heat-generating component, used in simulation in Example 10.

### [Reference Signs List]

- 1 ...: test piece
- 2 ...: upper rod
- 3 ...: lower rod
- 4 ...: upper joint block
- 5 ...: lower joint block
- 6 ...: temperature sensor
- 7 ...: heater
- 8 ...: heat insulation board
- 9 ...: ceramic heater
- 10 ..: aluminum plate
- 11 ..: sheet type thermocouple
- 12 ..: polyimide tape
- 13 ..: test piece
- 14 ..: acrylic plate
- 15 ..: sheet type thermocouple
- 16 ..: weight
- 17 ..: component to be protected
- 18 ..: heat-generating component
- 19 ..: pressure-sensitive adhesive layer
- 20 ..: heat-insulating layer
- 21 ..: heat-conducting layer

### [Description of Embodiment]

The present invention is a heat insulation/heat dissipation sheet that is formed by laminating, in order, a pressure-sensitive adhesive layer or a heat-conducting pressure-sensitive adhesive layer, a heat-conducting layer, a pressure-sensitive adhesive layer or a heat-insulating pressure-sensitive adhesive layer, a heat-insulating layer, and a pressure-sensitive adhesive layer or a heat-insulating pressure-sensitive adhesive layer between a heat-generating component (including a component that is not a component intended for heat generation but generates heat by being energized and operated or worked) and a component to be protected, adjacent to the heat-generating component, as described above, and interposed when adhered to these components. The present invention is a heat insulation/heat dissipation sheet that is formed by laminating, in order, a heat-conducting layer, a pressure-sensitive adhesive layer or a heat-insulating pressure-sensitive adhesive layer, and a heat-insulating layer when the heat insulation/heat dissipation sheet can be closely contacted with a heat-generating component and a component to be protected, without being adhered, and the like.
Thus, it is intended that heat conducted to the component to be protected is reduced as much as possible by transferring heat generated from the heat-generating component to the heat-conducting layer via the pressure-sensitive adhesive layer or the heat-conducting pressure-sensitive adhesive layer as required, to dissipate heat from the heat-conducting layer as well as further providing the heat-insulating layer provided via the pressure-sensitive adhesive layer or the heat-insulating pressure-sensitive adhesive layer provided on the heat-conducting layer, and further adhering or closely contacting the component to be protected, with the heat-insulating layer via the pressure-sensitive adhesive layer or the heat-insulating pressure-sensitive adhesive layer as required, rather than simply integrating the heat-generating component with the component to be protected.

In this manner, the amount of heat transferred to the heat-insulating layer is reduced by integrating the heat-generating component with the component to be protected by the heat insulation/heat dissipation sheet as well as actively transferring heat generated from the heat-generating component to the heat-conducting layer and dissipating the heat from the heat-conducting layer. Then, the amount of heat to be insulated by the heat-insulating layer is also reduced, and therefore, a load for heat insulation applied to the heat-insulating layer is reduced. Therefore, the heat-insulating layer can more effectively insulate heat generated by the heat-generating component.
Then, the heat dissipation and heat insulation effects of the entire heat insulation/heat dissipation sheet are sufficiently exhibited due to the presence of the heat-conducting layer and the heat-insulating layer, and by reducing the amount of heat received by the component to be protected, an excessive temperature increase of the component to be protected can be prevented.

Regarding the heat insulation/heat dissipation sheet of the present invention, the size and shape of each layer depend on the size and shape of the heat-generating component and the component to be protected. When the pressure-sensitive adhesive layer for adhering the heat-conducting layer to the heat-generating component is provided, since the pressure-sensitive adhesive layer is a layer for exhibiting adhesion to the heat-generating component and the action of transferring heat toward the heat-conducting layer, the size and shape of the pressure-sensitive adhesive layer need to be the same as the size and shape of the heat-generating component because of firmer adhesion and a need to transfer a larger amount of heat to the heat-conducting layer.

By containing a filler composed of a material having good heat conductivity, and the like in this pressure-sensitive adhesive for adhering the heat-generating component to the heat-conducting layer, the heat conductivity of the entire pressure-sensitive adhesive layer increases, and heat from the heat-generating component can be more actively transferred toward the heat-conducting layer.

Since the heat-conducting layer is a layer that absorbs and dissipates heat from the heat-generating component, the heat-conducting layer is required to sufficiently absorb and dissipate heat from the heat-generating component via the pressure-sensitive adhesive layer as required, and therefore, the heat-conducting layer is required to have the same size and shape as the pressure-sensitive adhesive layer, or a shape larger than that of the pressure-sensitive adhesive layer. Particularly, when the heat-conducting layer has a shape larger than that of the pressure-sensitive adhesive layer, part of the heat-conducting layer protrudes from the pressure-sensitive adhesive layer, and the protruding portion particularly contributes to heat dissipation. Of course, also when the heat-conducting layer has the same size and shape as the pressure-sensitive adhesive layer, heat can be dissipated particularly from the ends of the heat-conducting layer.
This point is also similar when the heat insulation/heat dissipation sheet does not have the pressure-sensitive adhesive layer. When the heat-conducting layer is larger than the heat-generating component, part of the heat-conducting layer protruding particularly contributes to heat dissipation.

Further, the pressure-sensitive adhesive layer for adhering the heat-insulating layer to the heat-conducting layer is a layer for providing the heat-insulating layer between the heat-conducting layer and the component to be protected, and is a layer that does not have a need to actively transfer heat from the heat-conducting layer toward the heat-insulating layer. In order to firmly adhere the heat-insulating layer to the heat-conducting layer, when the shapes or sizes of the heat-conducting layer and the heat-insulating layer are different, it is necessary that the pressure-sensitive adhesive layer is provided, with the same size and shape as a smaller one.
The heat-insulating layer is a layer for blocking heat that is generated from the heat-generating component and cannot be completely dissipated even by the heat dissipation member, so as to transfer the heat to the component to be protected, as little as possible, and may comprise a foamed layer, an air layer, or the like as in conventional techniques regarding general heat insulation sheets.

The heat-insulating layer is formed with a size equal to or larger than that of the component to be protected, and therefore, heat received by the heat-conducting layer can be sufficiently insulated.
The heat-insulating layer is a layer intended to protect a component that receives some adverse effect by being heated, that is, the component to be protected, from heat, and therefore, it is necessary that the heat-insulating layer has the same size as the heat-conducting layer, or a size equal to or larger than that of the heat-conducting layer, and has the same size as the component to be protected or is larger than the component to be protected. As a result, by sufficiently insulating heat received by the heat-conducting layer, a sufficient heat insulation action can be exhibited for other components to be protected.

The pressure-sensitive adhesive layer formed between the heat-insulating layer and the component to be protected, as required, may have the same size and shape as the component to be protected, and, in some cases, is a layer that does not have a need to transfer heat from the heat-insulating layer to the component to be protected, as in the pressure-sensitive adhesive layer formed between the heat-conducting layer and the heat-insulating layer. Therefore, this pressure-sensitive adhesive layer between the heat-insulating layer and the article to be protected may comprise a foamed layer, an air layer, or the like as in the pressure-sensitive adhesive layer between the heat-conducting layer and the heat-insulating layer.
Of course, even if the heat insulation/heat dissipation sheet does not have such a pressure-sensitive adhesive layer, it is not essential to provide the pressure-sensitive adhesive layer as long as the heat insulation/heat dissipation sheet can closely contact, or contact, with the component to be protected. Further, the component to be protected may be spaced from the heat insulation/heat dissipation sheet. In other words, the present invention connects the heat-generating component to the component to be protected, adjacent to the heat-generating component, between these components, and the heat-insulating layer and the component to be protected can also be apart from each other regardless of the presence or absence of the pressure-sensitive adhesive layer between them. In the present invention, connecting includes a case where the heat-insulating layer and the component to be protected do not contact with each other directly or via the pressure-sensitive adhesive layer.

### (Heat-Generating Component and Component to Be Protected)

The heat-generating component may be an electronic component that has the property of generating heat particularly by being energized by the operation of electronic equipment, for example, a CPU, an IC, a transistor, a coil, a capacitor, a transformer, or a cathode tube, or a component that generates heat by the operation of electronic equipment, such as a secondary battery, such as a lithium ion battery. Further, the heat-generating component may be a component that generates heat by the working of a machine component or the like that generates heat by the sliding of a bearing or the like.
The component to be protected is an electronic component that does not particularly generate heat even if being energized by the operation of electronic equipment, and moreover has the possibility of not being able to exhibit stable performance at high temperature. Examples thereof include secondary batteries, such as lithium ion batteries, display portions, such as liquid crystals and organic EL elements, LEDs, diodes, image pickup elements, or measurement devices that require temperature control.
Examples of equipment in which the heat-generating component and the component to be protected are closely disposed include wireless power transmission modules. When a wireless power transmission module is placed in small electronic equipment, such as portable equipment or a personal computer, heat generating sites, such as a coil and a control IC, and a component to be protected, such as a secondary battery, such as a lithium ion battery, are closely placed in a narrow space, and therefore, heat measures are important. Particularly, regarding equipment in which a secondary battery pack is integrated with a wireless power transmission module for miniaturization, heat measures are particularly important.
In addition, regarding an assembled battery using secondary batteries, such as nickel-hydrogen batteries or lithium ion batteries, connected in parallel or in series, the constituting batteries themselves are heat-generating components and are also components to be protected.
Therefore, the heat insulation/heat dissipation sheet of the present invention is used in these applications and the like.

### (Pressure-Sensitive Adhesive Layer)

The pressure-sensitive adhesive layer in the present invention is a pressure-sensitive adhesive layer that is not included in the following heat-conducting pressure-sensitive adhesive and the following heat-insulating pressure-sensitive adhesive, in other words, additives and a filler are not blended for heat conductivity improvement and heat insulation properties improvement, or a particular layer structure, such as containing bubbles or a pattern of pressure-sensitive adhesive-coated portions and non-pressure-sensitive adhesive-coated portions being formed, is not employed for heat insulation.
The resin used for the pressure-sensitive adhesive layer used in the present invention is not particularly limited, and (meth)acrylic, natural rubber-based, synthetic rubber-based, silicone-based, and urethane-based pressure-sensitive adhesives, and the like can be used. For these pressure-sensitive adhesives, the same pressure-sensitive adhesive may be used for all, or a different pressure-sensitive adhesive may be used depending on the site.

When this pressure-sensitive adhesive layer is used for the adhesion of the heat-generating component to the heat-conducting layer, the thickness of the pressure-sensitive adhesive layer is preferably 0.5 mm or less, more preferably 0.1 mm or less, and further preferably 0.050 mm or less.
In addition, when this pressure-sensitive adhesive layer is used for the adhesion of the heat-conducting layer to the heat-insulating layer, and the adhesion of the heat-insulating layer to the component to be protected, the thickness of the pressure-sensitive adhesive layer is preferably 0.05 mm or more, more preferably 0.1 mm or more, and further preferably 1.0 mm or more.

The additives and the like blended in the pressure-sensitive adhesive used in the present invention is not particularly limited, and those generally used as rubber or plastic blending agents, such as a dispersing agent,
an antiaging agent, an antioxidant, a processing aid, a stabilizer, an antifoaming agent, a flame retardant, a thickening agent, and a pigment, can be appropriately added in a range in which the effect of the present invention is not impaired.
The property of not being altered by heat emitted from the heat-generating component is demanded of the above resin and additives in common.

### (Heat-Conducting Pressure-Sensitive Adhesive Layer)

For a pressure-sensitive adhesive used in a place conscious of heat conductivity and heat dissipation, a thin layer pressure-sensitive adhesive is preferably used. The thickness of the pressure-sensitive adhesive layer at this time is preferably 0.5 mm or less, more preferably 0.1 mm or less, and further preferably 0.050 mm or less.

When it is desired to further increase heat conductivity and heat dissipation properties in the pressure-sensitive adhesive used in a place conscious of heat conductivity and heat dissipation, or when unevenness and clearances cannot be filled with the thin layer pressure-sensitive adhesive, and it is necessary to thicken the pressure-sensitive adhesive, a pressure-sensitive adhesive containing a heat-conducting filler can be used.

The material used for the heat-conducting, filler-containing pressure-sensitive adhesive in the present invention is not particularly limited. Materials that can have both heat conductivity and adhesiveness are preferred, and for example, a heat-conducting organic resin composition in which a heat-conducting filler is contained in a polymer component, such as an epoxy-based resin, a thermoplastic elastomer, a silicone rubber, or an acrylic polymer, is preferably used.

The heat-conducting filler used in the present invention is not particularly limited, and particles of boron nitride, aluminum nitride, silicon nitride, gallium nitride, aluminum hydroxide, magnesium hydroxide, silicon carbide, silicon dioxide, aluminum oxide, titanium oxide, zinc oxide, tin oxide, copper oxide, nickel oxide, antimonic acid-doped tin oxide, calcium carbonate, barium titanate, potassium titanate, copper, silver, gold, nickel, aluminum, platinum, carbon black, carbon tubes (carbon nanotubes), carbon fibers, diamond, and the like, can be used. These heat-conducting fillers may be used alone, or two or more may be used in combination.

The shape of the heat-conducting filler used in the present invention is not particularly limited and may be a bulk shape, a needle shape, a plate shape, or a layer shape. The bulk shape includes a spherical shape, a rectangular parallelepiped shape, a crushed shape, or an irregular shape thereof.

In the present invention, for the size of the heat-conducting filler, in the case of a bulk-shaped (spherical) heat-conducting filler, the primary average particle diameter is 0.1 to 1000 µm, preferably 1 to 100 µm, and further preferably 2 to 20 µm. If the primary average particle diameter is more than 1000 µm, a problem is that the heat-conducting filler exceeds the thickness of the heat conduction resin layer to cause thickness variations.

When the heat-conducting filler is a needle-shaped or plate-shaped heat-conducting filler, the maximum length is 0.1 to 1000 µm, preferably 1 to 100 µm, and further preferably 2 to 20 µm. If the maximum length is more than 1000 µm, a problem is that the heat-conducting filler aggregates easily, and handling is difficult.
Further, the aspect ratio (expressed in long axis length/short axis length, or long axis length/thickness, in the case of a needle-shaped crystal, and expressed in diagonal length/thickness, or long side length/thickness, in the case of a plate-shaped crystal) of these is 1 to 10000, preferably 10 to 1000.

For such a heat-conducting filler, general commercial products can be used. Examples of boron nitride can include "HP-40" manufactured by Mizushima Ferroalloy Co., Ltd., and "PT620" manufactured by Momentive Performance Materials Inc. Examples of aluminum hydroxide can include "HIGILITE HS-32" and "HIGILITE H-42" manufactured by Showa Denko K.K. Examples of aluminum oxide can include "AS-50" manufactured by Showa Denko K.K. Examples of magnesium hydroxide can include "KISUMA 5A" manufactured by Kyowa Chemical Industry Co., Ltd. Examples of antimonic acid-doped tin oxide can include "SN-100S," "SN-100P," and "SN-100D (water-dispersed product)" manufactured by ISHIHARA SANGYO KAISHA, LTD. Examples of titanium oxide can include "TTO series" manufactured by ISHIHARA SANGYO KAISHA, LTD. Examples of zinc oxide can include "SnO-310," "SnO-350," and "SnO-410" manufactured by Sumitomo Osaka Cement Co., Ltd.

In the present invention, the amount of the heat-conducting filler used is 10 to 1000 parts by weight, preferably 50 to 500 parts by weight, and further preferably 100 to 400 parts by weight, with respect to 100 parts by weight of the polymer component. If the amount of the heat-conducting filler used is more than 1000 parts by weight, problems are that flexibility decreases and that pressure-sensitive adhesive force decreases. If the amount of the heat-conducting filler used is less than 10 parts by weight, sufficient heat conductivity may not be provided.

In addition, in the heat-conducting organic resin composition of the present invention, a silane coupling agent can be used for the purpose of further improving adhesive force, durability, and the affinity of the heat-conducting filler particles for the polymer component, such as an acrylic polymer. As the silane coupling agent, a publicly known one can be appropriately used without particular limitation.

Specific examples of the silane coupling agent include epoxy group-containing silane coupling agents, such as 3-glycidoxypropyltrimethoxysilane, 3-glycidoxypropyltriethoxysilane, 3-glycidoxypropylmethyldiethoxysilane, and 2-(3,4-epoxycyclohexyl)ethyltrimethoxysilane, amino group-containing silane coupling agents, such as 3-aminopropyltrimethoxysilane, N-2-(aminoethyl)-3-aminopropylmethyldimethoxysilane, and 3-triethoxysilyl-N-(1,3-dimethylbutylidene)propylamine, (meth)acryl group-containing silane coupling agents, such as 3-acryloxypropyltrimethoxysilane and 3-methacryloxypropyltriethoxysilane, and isocyanate group-containing silane coupling agent, such as 3-isocyanatepropyltriethoxysilane. Using such silane coupling agents is preferred for an improvement in durability.

The above silane coupling agents may be used alone, and two or more may be mixed and used. For the total content, with respect to 100 parts by weight of the above acrylic polymer, 0.01 to 10 parts by weight of the above silane coupling agent is preferably contained, 0.02 to 5 parts by weight of the above silane coupling agent is more preferably contained, and 0.05 to 2 parts by weight of the above silane coupling agent is further preferably contained. By using the above silane coupling agent in the above range, cohesive force and durability can be more reliably improved. On the other hand, if the above silane coupling agent is less than 0.01 parts by weight, the surfaces of the heat-conducting filler particles contained in the heat-conducting organic resin composition cannot be covered, and affinity may not be improved. On the other hand, if the above silane coupling agent is more than 10 parts by weight, heat conductivity may be decreased.

### (Heat-Insulating Pressure-Sensitive Adhesive Layer)

For a pressure-sensitive adhesive used in a place conscious of heat insulation properties, a thick layer pressure-sensitive adhesive is preferably used. The thickness of the pressure-sensitive adhesive layer at this time is preferably 0.05 mm or more, more preferably 0.1 mm or more, and further preferably 1.0 mm or more. The heat-insulating pressure-sensitive adhesive layer may be one pressure-sensitive adhesive layer, but may be a layer composed of a double-sided pressure-sensitive adhesive tape formed by providing a heat-insulating pressure-sensitive adhesive layer on both surfaces of a substrate film of a resin or the like.

When it is desired to further increase heat insulation properties in the pressure-sensitive adhesive used in a place conscious of heat insulation properties, or when a sufficient space cannot be ensured with the thick layer pressure-sensitive adhesive, and it is necessary to thin the pressure-sensitive adhesive, a pressure-sensitive adhesive containing air or gas can be used.

The pressure-sensitive adhesive containing air or gas used in the present invention is not particularly limited. Examples of the pressure-sensitive adhesive containing air or gas can include a foamable pressure-sensitive adhesive containing air or gas bubbles, a pressure-sensitive adhesive containing microcapsules containing air or gas, a pressure-sensitive adhesive formed in a mesh shape by randomly spraying it by a spray or a nozzle, and a pressure-sensitive adhesive layer in which a pattern of pressure-sensitive adhesive-coated portions and non-pressure-sensitive adhesive-coated portions, formed in a stripe, houndstooth check, or grid shape or the like, is formed. In any of the pressure-sensitive adhesives, an effect can be expected in which by containing air or gas in the layer and/or reducing the contact area of the heat-insulating pressure-sensitive adhesive layer with respect to the heat-conducting layer, the air or the gas improves heat insulation properties to decrease heat conductivity more than a solidly formed pressure-sensitive adhesive.

### (Heat-Conducting Layer)

The heat-conducting layer used in the present invention is not particularly limited, and examples of the heat-conducting layer can include metal sheets, such as copper and aluminum, graphite sheets, and rubber sheets and resin sheets containing heat-conducting fillers. Among these, metal sheets and graphite sheets, which are substrates having high heat conductivity, are more preferred.

### (Heat-Insulating Layer)

The heat-insulating layer used in the present invention is not particularly limited, and foamed sheets, such as urethane foams, polyethylene foams, silicone foams, polystyrene foams, and phenol foams, glass wool sheets, rock wool sheets, ceramic fiber sheets, glass fiber sheets, felt sheets, nonwoven fabric sheets, resin sheets containing microcapsules containing air, such as glass beads, and the like can be used. Among these, foamed sheets, such as polyethylene foams, which are materials having low heat conductivity, are preferred.

### (Layer Configuration of Heat Insulation/Heat Dissipation Sheet)

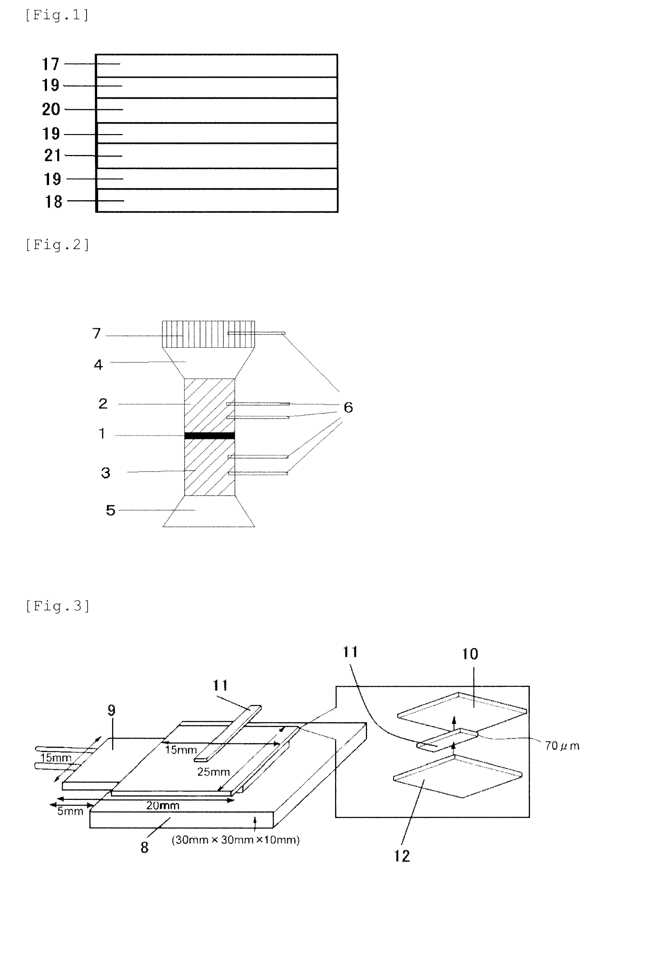

The heat insulation/heat dissipation sheet and intra-device structure of the present invention are formed by laminating the above materials.
When the heat insulation/heat dissipation sheet of the present invention is used for a heat-generating component and a component to be protected, the following intra-device structure is formed.
The intra-device structure has a configuration formed by contacting a layer composed of a heat-conducting layer 21 with a heat-generating component 18, providing a layer composed of a heat-insulating layer 20 on the heat-conducting layer 21 via a layer composed of a pressure-sensitive adhesive 19 or a heat-insulating pressure-sensitive adhesive, and facing the heat-insulating layer 20 toward a component to be protected 17 regardless of contact or noncontact, which is a case where a pressure-sensitive adhesive 19 is not used in Figure 1. Of the configuration, a layer configuration excluding the heat-generating component 18 and the component to be protected 17 is the heat insulation/heat dissipation sheet of the present invention.
When the heat insulation/heat dissipation sheet of the present invention is adhered to a heat-generating component and a component to be protected, the following intra-device structure is formed.
The intra-device structure is a device structure having a configuration formed by providing a layer composed of a heat-conducting layer 21 on a heat-generating component 18 via a layer composed of a pressure-sensitive adhesive 19 or a heat-conducting pressure-sensitive adhesive, further providing a layer composed of a heat-insulating layer 20 on the layer composed of the heat-conducting layer 21 via a layer composed of a pressure-sensitive adhesive 19 or a heat-insulating pressure-sensitive adhesive, and further adhering a component to be protected 17 to the layer composed of the heat-insulating layer 20 via a layer composed of a pressure-sensitive adhesive 19 or a heat-insulating pressure-sensitive adhesive, as shown in Figure 1.

In these configurations, the heat-conducting layer and the heat-insulating layer are each composed of one layer. But, it is also possible to employ a layer formed by laminating two or more heat-conducting layers with a heat-conducting pressure-sensitive adhesive layer, as a layer composed of a heat-conducting layer, and it is also possible to employ a layer formed by laminating two or more heat-insulating layers with a pressure-sensitive adhesive layer and/or a heat-insulating pressure-sensitive adhesive layer, as a layer composed of a heat-insulating layer, or form the heat-insulating layer and one or two heat-insulating pressure-sensitive adhesive layers of the same material.

### (Method for Manufacturing Heat Insulation/Heat Dissipation Sheet)

A method for manufacturing the heat insulation/heat dissipation sheet of the present invention can employ general methods of usual methods for manufacturing laminates.
For example, when a pressure-sensitive adhesive layer or a heat-conducting pressure-sensitive adhesive layer, and a pressure-sensitive adhesive layer or a heat-insulating pressure-sensitive adhesive layer are provided, a pressure-sensitive adhesive layer or a heat-conducting pressure-sensitive adhesive layer is formed on the releasable surface of a release sheet, and a heat-conducting layer is bonded to the pressure-sensitive adhesive layer or the heat-conducting pressure-sensitive adhesive layer. Apart from this, a sheet formed by forming a pressure-sensitive adhesive layer or a heat-insulating pressure-sensitive adhesive layer on both surfaces of a heat-insulating layer and laminating a release sheet on one pressure-sensitive adhesive layer or heat-insulating pressure-sensitive adhesive layer is prepared.
By bonding the pressure-sensitive adhesive layer or the heat-insulating pressure-sensitive adhesive layer on the side of the separately prepared sheet on which the release sheet is not laminated, to the surface of the above heat-conducting layer and applying pressure, the heat insulation/heat dissipation sheet of the present invention can be manufactured.
Of course, the method for laminating the layers of the heat insulation/heat dissipation sheet of the present invention is not limited to this example.

### [Examples]

### (Measurement of Heat Resistance Value)

The measurement of the heat resistance value of a heat-insulating layer was performed by a heat flow rate method using a thermal properties evaluation device (TCS-200 manufactured by ESPEC Corp.). A simplified diagram is shown in Figure 2. A test piece 1 was cut into a size of 20 mm by 20 mm and sandwiched between an upper rod 2 and a lower rod 3 by an upper joint block 4 and a lower joint block 5 without biting bubbles. For five temperature sensors 6, two temperature sensors 6 were embedded in each of the upper rod 2 and the lower rod 3, and one temperature sensor 6 was also embedded in a heater 7. Then, a load of 100 N was applied from the top of the heater 7 to fix the test piece. The compression bonding load per unit area was 25 N/cm². Then, the heater 7 was heated to 80°C, and the temperature of each spot was measured at intervals of 5 seconds. A state in which the heat flow rate was stable was determined as a steady state, and the average of measured values during 100 seconds at this time was calculated, and taken as a heat resistance value ((cm²·K)/W).

### (Heat Dissipation and Heat Insulation Properties Evaluation)

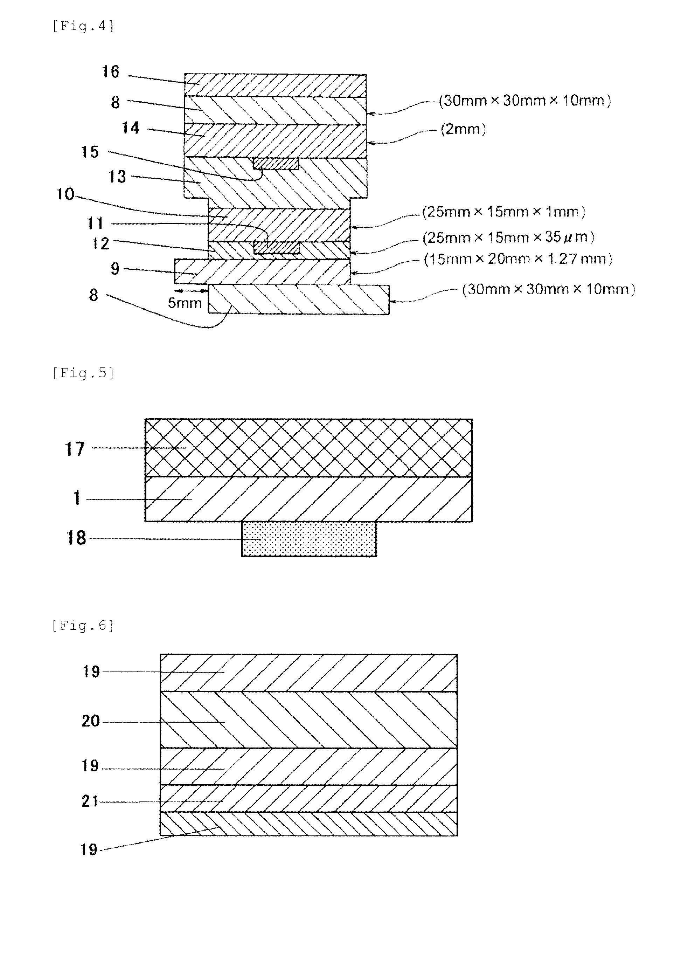

The evaluation of heat dissipation properties and heat insulation properties were performed using a device shown in Figures 3 and 4.
First, as shown in Figure 3, a planar ceramic heater 9 (20 mm long by 15 mm wide by 1.27 mm thick, MMCPH-20-15 manufactured by MISUMI Corporation) was placed on a heat insulation board 8 (30 mm long by 30 mm wide by 10 mm thick, HIPAL-30-30-10 manufactured by MISUMI Corporation) using a heat-conducting adhesive (KE-3493 manufactured by Shin-Etsu Silicone). The ceramic heater 9 was adhered with 5 mm of a terminal portion, as an unheated portion, protruding outside the heat insulation board 8. (The adhesion surface was 15 mm by 15 mm). Next, a 0.07 mm thick sheet type thermocouple 11 (Sheet Couple C060-K manufactured by CHINO CORPORATION) was fixed to the planar central portion of an aluminum plate 10 (15 mm long by 25 mm wide by 1 mm thick) so as to be sandwiched with a polyimide tape 12 (substrate thickness: 25 µm, pressure-sensitive adhesive thickness: 10 µm).

The aluminum plate 10 and the planar ceramic heater 9 were fixed to each other, using an oil compound (G-746 manufactured by Shin-Etsu Silicone), so that the surface to which the sheet type thermocouple 11 was fixed was on the ceramic heater 9 side as viewed from the aluminum plate, as shown in Figure 4. Then, a test piece 13 shown in the following Examples was sandwiched between the above-described aluminum plate 10 (thickness: 1 mm) (the surface to which the thermocouple was not fixed) and an acrylic plate 14 (thickness: 2 mm, ACRYLITE manufactured by MITSUBISHI RAYON CO., LTD.) and placed. At this time, a sheet type thermocouple 15 was placed between the test piece 13 and the acrylic plate 14 so that the test piece temperature could be measured. Then, a heat insulation board 8 and a weight 16 were placed on the acrylic plate 14 to apply a load to the test piece 13. (The total weight of the heat insulation board 8 and the weight 16 was 190.78 g). At an atmospheric temperature of 25°C, a current of 0.14 A and a voltage of 7.0 V were applied to the ceramic heater 9 for heating, and after a steady state was reached (after 30 minutes), the temperature of the aluminum plate 10 and the surface temperature of the test piece 13 were measured by respective thermocouples 11 and 15 and recorded.
In this evaluation method, the aluminum plate 10 corresponds to the heat-generating component in the present invention, and the acrylic plate 14 corresponds to the component to be protected in the present invention. The results of the following Examples and Comparative Examples are shown in Table 1.

### (Example 1)

A polyethylene foam sheet having a thickness of 1.0 mm and a heat resistance value of 20.26 cm²·K/W (Softlon S #1001 manufactured by SEKISUI CHEMICAL CO., LTD.) was used as a heat-insulating layer, and a synthetic rubber-based pressure-sensitive adhesive layer having a thickness of 0.10 mm was formed on both surfaces of the polyethylene foam sheet. An aluminum foil having a thickness of 0.040 mm and a heat resistance value of 1.13 cm²·K/W (BESPA manufactured by Sumikei Aluminum Foil Co., Ltd.) as a heat-conducting layer was bonded to one pressure-sensitive adhesive surface formed on the heat-insulating layer. Then, in order to carry out heat dissipation and heat insulation evaluation, the other pressure-sensitive adhesive surface formed on the heat-insulating layer was bonded to an acrylic plate having a size of 30 mm long by 30 mm wide. At this time, a sheet type thermocouple was placed between the sample and the acrylic plate so that the test piece temperature could be measured. Then, a heat-generating aluminum plate (15 mm long by 25 mm wide) equipped with a ceramic heater and the aluminum foil surface were fixed to each other with an acrylic pressure-sensitive adhesive (15 mm long by 25 mm wide) having a thickness of 0.05 mm and a heat resistance value of 3.99 cm²·K/W, and the evaluation of heat dissipation and heat insulation properties was performed by the above-described method.

### (Example 2)

Evaluation was performed as in Example 1 except that in Example 1, the heat-conducting layer was changed to a graphite sheet having a thickness of 0.025 mm and a heat resistance value of 0.35 cm²·K/W (EYGS182303 manufactured by Panasonic Electric Works Co., Ltd.).

### (Example 3)

Evaluation was performed as in Example 1 except that in Example 1, the heat-conducting layer was changed to a copper foil having a thickness of 0.035 mm and a heat resistance value of 1.46 cm²·K/W.

### (Example 4)

A reaction container equipped with a cooling tube, a nitrogen introduction tube, a thermometer, and a stirrer was used, and 70 parts by weight of butyl acrylate, 30 parts by weight of 2-ethylhexyl acrylate, 3 parts by weight of acrylic acid, 0.05 parts by weight of 4-hydroxybutyl acrylate, 0.1 parts by weight of 2,2'-azobisisobutyronitrile (initiator), and 155 parts by weight of toluene (solvent) were added. The atmosphere in the system was sufficiently replaced by nitrogen gas, and then, the system was heated at 80°C for 3 hours to obtain an acrylic polymer solution having 40.0% by weight of solids.
30 Parts by weight of the trade name "PENSEL D-125" manufactured by Arakawa Chemical Industries, Ltd., which was a rosin-based resin, as a tackifier resin, 100 parts by weight of the trade name "HIGILITE HS-32" (shape: crushed shape, particle diameter: 8 µm) manufactured by Showa Denko K.K., which was a heat-conducting aluminum hydroxide powder, 1 part by weight of the trade name "PLYSURF A212E" manufactured by Dai-ichi Kogyo Seiyaku Co., Ltd., as a dispersing agent, and 2 parts by weight of the trade name "CORONATE L" manufactured by NIPPON POLYURETHANE INDUSTRY CO., LTD., which was a polyfunctional isocyanate compound, as a crosslinking agent, were blended with 100 parts by weight (solids) of the above acrylic polymer solution, and the blend was stirred by a dispersion mixer for 15 minutes to adjust a heat-conducting organic resin composition.
The release-treated surface of a release film obtained by treating one surface of polyethylene terephthalate with a silicone release agent was coated with the obtained heat-conducting organic resin composition so that the thickness after drying was 0.050 mm, and the heat-conducting organic resin composition was dried at 70°C for 15 minutes to provide a heat-conducting pressure-sensitive adhesive layer. The heat resistance value of this heat-conducting pressure-sensitive adhesive layer was 3.99 cm²·K/W.
Evaluation was performed as in Example 1 except that in Example 1, this heat-conducting pressure-sensitive adhesive layer was used for the bonding of the heat-generating aluminum plate (15 mm long by 25 mm wide) equipped with a ceramic heater to the aluminum foil surface.

### (Example 5)

The acrylic pressure-sensitive adhesive (pressure-sensitive adhesive layer), the polyethylene foam sheet (heat-insulating layer), and the aluminum foil (heat-conducting layer) used in Example 1 were bonded and laminated in the order of the pressure-sensitive adhesive layer, the heat-insulating layer, the pressure-sensitive adhesive layer, the heat-insulating layer, the pressure-sensitive adhesive layer, and the heat-conducting layer. Then, the first pressure-sensitive adhesive surface was bonded to an acrylic plate having a size of 30 mm long by 30 mm wide. At this time, a sheet type thermocouple was placed between the sample and the acrylic plate so that the test piece temperature could be measured. Then, as in Example 1, a heat-generating aluminum plate equipped with a ceramic heater and the aluminum foil surface were fixed to each other with an acrylic pressure-sensitive adhesive, and the evaluation of heat dissipation and heat insulation properties was performed by the above-described method.

### (Example 6)

As in Example 1, a polyethylene foam sheet having a thickness of 1.0 mm and a heat resistance value of 20.26 cm²·K/W (Softlon S #1001 manufactured by SEKISUI CHEMICAL CO., LTD.) was used as a heat-insulating layer, and a synthetic rubber-based pressure-sensitive adhesive layer having a thickness of 0.10 mm was formed on both surfaces of the polyethylene foam sheet. A graphite sheet having a thickness of 0.025 mm and a heat resistance value of 0.35 cm²·K/W (EYGS182303 manufactured by Panasonic Electric Works Co., Ltd.) as a heat-conducting layer was bonded to one pressure-sensitive adhesive surface formed on the heat-insulating layer. Then, a graphite sheet having a thickness of 0.070 mm (EYG182307 manufactured by Panasonic Electric Works Co., Ltd.) was bonded to this graphite sheet, using the heat-conducting pressure-sensitive adhesive having a thickness of 0.050 mm described in Example 4. Then, as in Example 1, a heat-generating aluminum plate equipped with a ceramic heater and the aluminum foil surface were fixed to each other with an acrylic pressure-sensitive adhesive, and the evaluation of heat dissipation and heat insulation properties was performed by the above-described method.

### (Example 7)

A polyethylene terephthalate film having a thickness of 0.025 mm was coated with an SIS (styrene-isoprene-based thermoplastic elastomer)-based pressure-sensitive adhesive with a thickness of 0.030 mm by a hot melt method. Then, an SIS-based pressure-sensitive adhesive having a thickness of 0.030 mm was formed in stripes on the opposite surface of the polyethylene terephthalate film with the pattern interval of a coating width of 2 mm and an uncoating width of 2 mm to make a double-sided pressure-sensitive adhesive tape having a solidly coated layer on one surface and a stripe-coated layer on one surface.
Evaluation was performed as in Example 1 except that in Example 1, instead of the synthetic rubber-based pressure-sensitive adhesive layer, the above double-sided pressure-sensitive adhesive tape was used on both surfaces of the polyethylene foam sheet.
At this time, the above double-sided tape was disposed between the acrylic plate and the polyethylene foam sheet so that the stripe-coated surface was on the polyethylene foamed sheet side, and the above double-sided tape was disposed between the polyethylene sheet and the aluminum foil so that the stripe-coated surface was on the aluminum foil side.

### (Example 8)

The release-treated surface of a release film obtained by treating one surface of polyethylene terephthalate with a silicone release agent was spray-coated with an SIS (styrene-isoprene-based thermoplastic elastomer)-based pressure-sensitive adhesive with a coating amount of 4 g per 1 m², for example, by a method described in Japanese Patent Laid-Open No. 09-048460, or the like to form a pressure-sensitive adhesive layer containing an air layer and having air permeability.
Evaluation was performed as in Example 1 except that in Example 1, instead of the synthetic rubber-based pressure-sensitive adhesive layer, the above pressure-sensitive adhesive layer containing an air layer and having air permeability was used on both surfaces of the polyethylene foam sheet.

### (Example 9)

In Example 7, as the heat-conducting layer, a graphite sheet having a thickness of 0.025 mm and a heat resistance value of 0.35 cm²·K/W (EYGS182303 manufactured by Panasonic Electric Works Co., Ltd.) was used instead of the aluminum foil to fabricate a test piece. At this time, the evaluation of heat dissipation properties and heat insulation properties was performed with the size of an acrylic plate to which the test piece was to be bonded, and the test piece itself being a size of 15 mm long by 25 mm wide as in a heat-generating aluminum plate equipped with a ceramic heater.

### (Comparative Example 1)

An acrylic pressure-sensitive adhesive having a thickness of 0.05 mm and a heat resistance value of 3.99 cm²·K/W was bonded to an aluminum foil having a thickness of 0.040 mm and a heat resistance value of 1.13 cm²·K/W (BESPA manufactured by Sumikei Aluminum Foil Co., Ltd.) as a heat-conducting layer, and then, the aluminum foil was bonded to an acrylic plate 30 mm long by 30 mm wide. At this time, a sheet type thermocouple was placed between the sample and the acrylic plate so that the test piece temperature could be measured. Then, a heat-generating aluminum plate (15 mm long by 25 mm wide) equipped with a ceramic heater and the aluminum foil surface were fixed to each other with an acrylic pressure-sensitive adhesive (15 mm long by 25 mm wide) having a thickness of 0.05 mm and a heat resistance value of 3.99 cm²·K/W, and the evaluation of heat dissipation and heat insulation properties was performed by the above-described method.

### (Comparative Example 2)

Evaluation was performed as in Comparative Example 1 except that in Comparative Example 1, instead of the heat conduction substrate, a polyethylene foam sheet having a thickness of 1.0 mm and a heat resistance value of 20.26 cm²·K/W (Softlon S #1001 manufactured by SEKISUI CHEMICAL CO., LTD.) was used as the heat-insulating layer.

### (Comparative Example 3)

An acrylic plate and a heat-generating aluminum plate equipped with a ceramic heater were fixed to each other using an acrylic pressure-sensitive adhesive (15 mm long by 25 mm wide) having a thickness of 0.05 mm and a heat resistance value of 3.99 cm²·K/W, and the evaluation of heat dissipation properties and heat insulation properties was performed. At this time, evaluation was performed with the size of the acrylic plate to which a test piece was to be bonded, and the test piece itself being a size of 15 mm long by 25 mm wide as in the heat-generating aluminum plate equipped with a ceramic heater.

### (Comparative Example 4)

Evaluation was performed as in Comparative Example 2 except that in Comparative Example 2, the size of the acrylic plate to which the test piece was to be bonded, and the test piece itself was a size of 15 mm long by 25 mm wide as in the heat-generating aluminum plate equipped with a ceramic heater.

### (Comparative Example 5)

Comparative Example 5 was an example in which the invention described in Patent Literature 3 was replicated, and was a structure in which a heat-conducting silicone sheet was provided on a heat-generating component, and a heat-insulating layer was further provided on the heat-conducting silicone sheet, and the edges of the heat-conducting silicone sheet contacted with a substrate surface supporting the heat-generating component, around the heat-generating component. Evaluation was performed under the same conditions as the Examples and other Comparative Examples except the layer configuration and except that the aluminum plate was 15 mm by 15 mm, and the heat-conducting silicone sheet was contacted with the member around the aluminum plate.

**[Table 1]**

| | Aluminum plate (as heat-generating component) temperature(°C) | Adherend (as component to be protected) temperature(°C) |
|---|---|---|
| Example 1 | 62.2 | 53.5 |
| Example 2 | 61.6 | 52.3 |
| Example 3 | 62.0 | 52.1 |
| Example 4 | 62.4 | 52.6 |
| Example 5 | 63.2 | 47.4 |
| Example 6 | 60.9 | 50.9 |
| Example 7 | 62.3 | 50.8 |
| Example 8 | 62.7 | 52.4 |
| Example 9 | 75.0 | 58.5 |
| Comparative Example 1 | 62.1 | 57.1 |
| Comparative Example 2 | 77.4 | 60.2 |
| Comparative Example 3 | 71.7 | 69.3 |
| Comparative Example 4 | 75.6 | 60.0 |
| Comparative Example 5 | 71.4 | 57.6 |

Examples 1 to 3 are examples that are common except that the material and thickness of the heat-conducting layer are different. According to these examples, it can be understood that when the graphite sheet was used as the heat-conducting layer, the temperature of the aluminum plate was the lowest, and heat was more effectively dissipated.

Example 4 is one in which the pressure-sensitive adhesive layer that adheres the heat-conducting layer to the aluminum plate in Example 1 is changed to the heat-conducting pressure-sensitive adhesive layer. In this example, the temperature of the aluminum plate does not change much with respect to the result of Example 1, but the adherend temperature clearly decreases. For this, it can be said that, of the amount of heat transferred from the aluminum plate to the heat-conducting pressure-sensitive adhesive layer and the aluminum foil, which was the heat-conducting layer, the amount of heat further transferred to the heat-insulating layer was smaller, and heat was efficiently dissipated from the heat-conducting pressure-sensitive adhesive layer and the aluminum foil.

Example 5 is an example in which for the heat-insulating layer in Example 1, the number of polyethylene foamed sheets is further increased by one. As a result, it is clear that the temperature of the aluminum plate increases slightly with respect to Example 1, but the adherend temperature decreases greatly. This reflects the fact that because of an intensified heat insulation effect due to two polyethylene foamed sheets, heat transferred from the aluminum plate to the heat-conducting layer was shielded by the heat-insulating layer, and only a little heat was transferred to the adherend.

Example 6 is an example in which the heat-conducting layer composed of one graphite sheet in Example 2 is changed to one formed by laminating two graphite sheets via a heat-conducting pressure-sensitive adhesive layer. As a result, the aluminum plate temperature and the adherend temperature both decrease further, and it can be understood that by increasing the number of layers of graphite sheets and also adding the heat-conducting pressure-sensitive adhesive layer, the heat-conducting layer composed of two graphite sheets and a heat-conducting pressure-sensitive adhesive layer absorbed a larger amount of heat from the aluminum plate, which was a heat-generating material, and further effectively dissipated the amount of heat absorbed.

Example 7 is one in which the synthetic rubber pressure-sensitive adhesive layer formed on both surfaces of the polyethylene foamed sheet in Example 1 is replaced by a stripe-coated pressure-sensitive adhesive tape formed by providing an SIS-based pressure-sensitive adhesive layer on one surface of a PET film and stripe-coating an SIS-based pressure-sensitive adhesive on the other surface. As a result, the temperature of the adherend decreases more greatly than the result of Example 1. This shows that particularly the stripe-coated surface of the stripe-coated pressure-sensitive adhesive tape formed space to have the effect of suppressing the conduction of heat, and thus, heat transferred to the aluminum foil was insulated by two stripe-coated pressure-sensitive adhesive tapes and the polyethylene foamed sheet.

Example 8 is an example in which the synthetic rubber pressure-sensitive adhesive layer in Example 1 is changed to a mesh-coated SIS-based pressure-sensitive adhesive. According to this result, the temperature of the adherend decreases more than the temperature in Example 1. It is clear that this is also due to the fact that heat conducted to the aluminum foil was prevented from being transferred to the adherend by the presence of two pressure-sensitive adhesive layers that was mesh-coated to contain bubbles inside.

Example 9 is an example in which the aluminum foil in Example 7 is changed to a graphite sheet having a thickness of 0.025 mm, and the heat-generating aluminum plate (15 mm long by 25 mm wide) and the test piece have the same size.
According to this result, the graphite sheet is not larger than the heat-generating aluminum plate (aluminum plate), providing a structure in which the entire graphite sheet is sandwiched between the heat-generating aluminum plate and the PET film, that is, a state in which the large surfaces, other than the extremely small end surfaces, of the graphite sheet, which is the heat-conducting layer, do not contact with the outside air.
This result shows that the temperature of the heat-generating aluminum plate and the temperature of the adherend are higher than those of the test piece in Example 7 in which the surface of the aluminum foil, which is a heat conduction substrate, contacts with the outside air, and heat from the heat-generating aluminum plate accumulates in the test piece.
However, compared with Comparative Example 4, which is common in that the heat-generating aluminum plate and the test piece have the same size, the temperature of the adherend to be protected remains 58.5°C, which is lower than 60.0°C in Comparative Example, and the effect of being able to further protect the adherend can be achieved.

With respect to these Examples, Comparative Example 1 is an example in which a heat-generating component, an aluminum foil, and an acrylic plate, which is an adherend, are only laminated with an acrylic pressure-sensitive adhesive. As a result, heat generated by the heat-generating component is transferred to the adherend through the aluminum foil, and therefore, the temperature of the heat-generating component decreases, but the temperature of the adherend increases, and no heat insulation effect is seen.

In addition, Comparative Example 2 is an example in which a heat-generating component, a polyethylene foamed sheet, and an acrylic plate, which is an adherend, are laminated with an acrylic pressure-sensitive adhesive, and heat generated by the heat-generating component is insulated by the polyethylene foamed sheet. Therefore, the temperature of the heat-generating component itself increases extremely, and simultaneously, the temperature of the adherend also increases probably because the polyethylene foamed sheet is insufficient to insulate the increased temperature of the heat-generating component.

Comparative Example 3 is an example in which a heat-generating component is adhered to an acrylic plate with an acrylic pressure-sensitive adhesive, and these layers have the same size. In this case, heat generated by the heat-generating component is transferred to the acrylic plate only via the acrylic pressure-sensitive adhesive layer, and therefore, the temperatures of the heat-generating component and the adherend both increase.

Comparative Example 4 is an example in which the layers in Comparative Example 2 have the same size, and the size of the polyethylene foamed sheet is smaller than that of Comparative Example 2. Therefore, heat generated by the heat-generating component does not remain, and therefore, the temperature of the heat-generating component decreases slightly more than the temperature in Comparative Example 2, but the heat-generating component and the adherend both have high temperature.

Comparative Example 5 is exclusively an example of a structure in which the edges of the heat-conducting silicone sheet contact with a substrate surface supporting the heat-generating component, around the heat-generating component. Although the heat-conducting silicone sheet is still larger than the heat-generating element, the temperatures of the heat-generating component and the adherend are both high temperatures.
For this, it is considered that since the edges of the heat-conducting silicone sheet contact with the substrate surface supporting the heat-generating component, around the heat-generating component, heat remains in the heat-generating component and its periphery and cannot be completely dissipated even by the heat-conducting silicone sheet, and therefore, the temperature of the adherend also increases.

Example 10 is an example in which for the heat insulation/heat dissipation effect according to the present invention, an experiment by simulation is performed.
In performing this experiment, the conditions were that a component to be protected 17, 37 mm long, 35 mm wide, and 5 mm thick, and having a heat conductivity of 0.67 W/mk, and a heat-generating component 18, 20 mm long, 15 mm wide, and 1 mm thick, and having a heat conductivity of 137 W/mk and a heat generation amount of 1.345 MW/m³ were used, these were laminated on a test piece 1, and the outside air temperature was 25°C, and a structure combination shown in Figure 5 was provided.
Further, simulation was performed changing the shape of the test piece 1 used, and the place where the test piece 1 was used. Simulation (heat transfer analysis) was carried out using the general-purpose finite element analysis software "MSC Mary."
1.345 MW/m³, which is the heat generation amount of the above heat-generating component 18, is a heat generation amount in which the heat-generating component 18 center temperature is about 70°C when the heat conductivity of the component to be protected 17 and the test piece 1 is 0.2 W/mk in the following shape 1.
The test pieces 1 used were common in that they are the heat insulation/heat dissipation sheets of the present invention having a structure shown in Figure 6. Analysis models composed of combinations of the component to be protected 17, the heat-generating component 18, and the test piece 1, shown in shapes 1 to 4, were made changing the relative size of this test piece 1 with respect to the component to be protected 17 and the heat-generating component 18. The test piece shown in Figure 6 is formed by laminating a pressure-sensitive adhesive layer 19, a heat-insulating layer 20, a pressure-sensitive adhesive layer 19, a heat-conducting layer 21, and a pressure-sensitive adhesive layer 19 in order from the top.
The properties of each layer common to these test pieces 1 are shown in the following Table 2.

**[Table 2]**

| | Thickness (mm) | Heat conductivity (W/mk) | Note |
|---|---|---|---|
| Pressure-sensitive adhesive layer 19 | 0.10 | 0.2 | Side of member to be protected |
| Heat insulation substrate layer 20 | 1.00 | 0.032 | |
| Pressure-sensitive adhesive layer 19 | 0.10 | 0.2 | |
| Heat-conducting substrate layer 21 | 0.025 | Plane direction 700 Thickness direction 5 | |
| Pressure-sensitive adhesive layer 19 | 0.050 | 0.2 | Heat-generating body side |

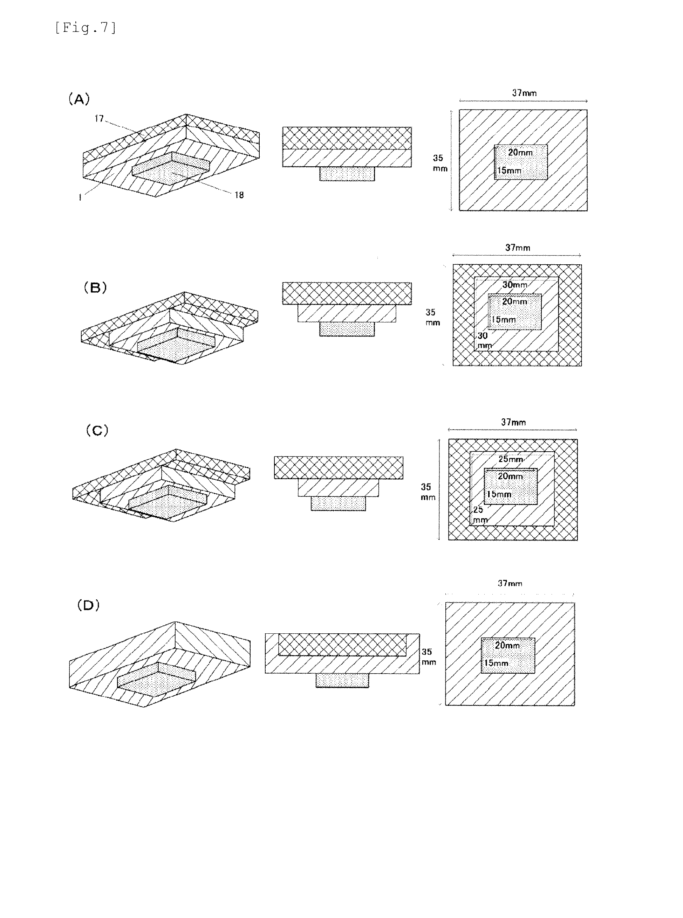

Using the test pieces composed of the layers having such properties, the component to be protected, the test piece, and the heat-generating component were combined so as to provide shapes shown in Figures 7(A) to 7(D), which were the shapes 1 to 4, respectively.
Simulation results in these shapes are shown in the following Table 3.

**[Table 3]**

| | Test piece attachment area (mm²) | (A) Heat-generating body center temperature (°C) | (B) Maximum temperature of member to be protected (°C) | (A)-(B) |
|---|---|---|---|---|
| Shape 1 | 1295 | 52.24 | 47.02 | 5.22 |
| Shape 2 | 900 | 56.71 | 48.60 | 8.11 |
| Shape 3 | 625 | 62.67 | 50.47 | 12.20 |
| Shape 4 | 2198.6 | 48.28 | 44.54 | 3.74 |

According to the results in the above Table 3, there is a tendency that when the test piece attachment area, that is, the area of the test piece 1, increases from the shape 3 to the shape 1, (A) heat-generating component center temperature and (B) the maximum temperature of the component to be protected decrease, and the difference between (A) and (B), that is, the difference between the heat-generating component 18 center temperature and the maximum temperature of the component to be protected 17, is reduced.
This tendency shows that when the area of the test piece 1, increases, an area in which heat transferred from the heat-generating component 18 can be dissipated also increases, and therefore, the temperature of the test piece 1 itself decreases, and therefore, the amount of heat further transferred from the heat-generating component 18 increases. This tendency also shows that when the temperature of the test piece 1 itself decreases, the amount of heat transferred from the test piece 1 to the component to be protected 17 decreases, and therefore, a temperature increase of the component to be protected 17 is suppressed.
At this time, it is seen that the extent of the temperature decrease of the heat-generating component 18 is larger than the temperature decrease of the component to be protected 17, and therefore, the temperature difference between the heat-generating component 18 and the component to be protected 17 is reduced, that is, the action of the test piece 1 sufficiently receiving heat from the heat-generating component 18 and dissipating the heat is large.
Particularly, when the test piece 1 and the component to be protected 17 have the same size, as in the shape 1, the temperature difference between the heat-generating component center temperature and the maximum temperature of the component to be protected is as small as 5.22°C.
Further, when the shape of the test piece of the shape 1 is changed so as to cover not only a surface of the component to be protected 17, but also the ends, that is, the side surfaces, of the component to be protected, as in the shape 4, as a result, the attachment area of the test piece 1 increases further, and therefore, more heat from the heat-generating component 18 can be transferred and further dissipated. Therefore, the heat-generating component center temperature and the maximum temperature of the component to be protected both decrease, and the temperature difference between these is only 3.74°C.
It is clear that the shape of the heat insulation/heat dissipation sheet of the present invention, the attachment place of the heat insulation/heat dissipation sheet of the present invention to the component to be protected 17, and the like can be determined considering the heat generation amount of the heat-generating component 18 and the heat resistance of the component to be protected 17.

According to such results, even if a plurality of combinations in which layers composed of a heat-conducting layer and a heat-insulating layer are laminated are used in the heat insulation/heat dissipation sheet of the present invention, a heat dissipation effect and a heat insulation effect can be exhibited. The temperature decrease of an adherend is not simply due to a heat insulation effect, and decreasing the amount of heat to be insulated, that is, heat dissipation by the heat-conducting layer and the heat-conducting pressure-sensitive adhesive layer, also contributes to the temperature decrease of an adherend. The effect according to the present invention is exhibited by the combination of the properties of the layers constituting the heat insulation/heat dissipation sheet.

## Claims

1. A heat insulation/heat dissipation sheet comprising a heat-conducting layer, a pressure-sensitive adhesive layer or a heat-insulating pressure-sensitive adhesive layer, and a heat-insulating layer laminated in order between a heat-generating component and a component to be protected, adjacent to the heat-generating component, for connecting the components.

2. An intra-device structure comprising a heat insulation/heat dissipation sheet according to claim 1 connected with a heat-conducting layer side thereof facing a heat-generating component side and a heat-insulating layer side thereof facing a component to be protected, in a device.

3. The heat dissipation/heat insulation sheet and the intra-device structure according to any of claim 1 or 2, wherein an area of the heat insulation/heat dissipation sheet is larger than a footprint of the heat-generating component.

4. The heat dissipation/heat insulation sheet and the intra-device structure according to any of claims 1 to 3, wherein a heat insulation/heat dissipation sheet according to claim 1 is continuously placed not only on a surface of the component to be protected but also on at least one end of the component to be protected.
